# EUROPÄISCHE PATENTSCHRIFT

(11) **EP 2 988 914 B1**
(45) Veröffentlichungstag und Bekanntmachung des Hinweises auf die Patenterteilung: **17.05.2017**
(21) Anmeldenummer: 14716794.4
(22) Anmeldetag: 08.04.2014
(51) Int. Cl.: B29C 35/08, B29C 35/02, B29C 37/00, B29D 11/00, B29C 43/00, B29C 43/32, B29K 101/00, B29C 43/58, B29K 105/24

(54) **VORRICHTUNG UND VERFAHREN ZUR HERSTELLUNG EINER STRUKTUR AUS AUSHÄRTBAREM MATERIAL DURCH ABFORMUNG**
DEVICE AND METHOD FOR PRODUCING A STRUCTURE FROM CURABLE MATERIAL BY IMPRESSION
DISPOSITIF ET PROCÉDÉ DE FABRICATION D'UNE STRUCTURE EN MATÉRIAU DURCISSABLE PAR MOULAGE

(30) Priorität: 22.04.2013 DE 102013207243
(43) Veröffentlichungstag der Anmeldung: 02.03.2016
(73) Patentinhaber: Fraunhofer-Gesellschaft zur Förderung der angewandten Forschung e.V., 80686 München (DE)
(72) Erfinder: WIPPERMANN, Frank, 98617 Meiningen (DE); REIMANN, Andreas, 99510 Apolda (DE); DUNKEL, Jens, 07745 Jena (DE); BRÄUER, Andreas, 07646 Schlöben (DE)
(74) Vertreter: Schenk, Markus
(86) Internationale Anmeldenummer: PCT/EP2014/057064
(87) Internationale Veröffentlichungsnummer: WO 2014/173676

(56) Entgegenhaltungen:
- EP-A1- 0 637 490
- EP-A2- 0 322 353
- WO-A1-2011/085880
- US-A1- 2007 018 360

## Beschreibung

Die vorliegende Erfindung bezieht sich auf die Herstellung von Strukturen aus aushärtbarem Material durch Abformung und ein Verfahren zum Aushärten desselben durch eine Strahlung.

UV-härtende Kunststoffe, wie beispielsweise Ormocere, UV-Klebstoffe von Delo, Norland, Epoxy Technology oder Panacol-Elosol schwinden während der Bestrahlung im Bereich einiger Prozent des Volumens. Werden die Kunststoffe während eines Herstellungsprozesses abgeformt und anschließend bestrahlt, resultieren Formabweichungen zwischen Werkzeug und abgeformter Struktur, die speziell bei optischen Anwendungen nicht akzeptiert werden können.

Die Abformung unter Nutzung von UV-härtbaren Polymeren erfolgt unter anderem in zwei Varianten und dadurch bedingt in zwei verschiedenen Arten von Geräten. Das Verfahren beinhaltet entweder die Abformung vieler Strukturen zeitgleich, parallel miteinander auf großer Fläche oder die wiederholte Abformung einzelner Strukturen in einem sequenziellen Prozess, wobei die einzelnen Abformungen auf einem gemeinsamen Substrat räumlich nebeneinander ausgeführt werden.

Die erste Prozessvariante erfolgt zumeist in einem Mask-Aligner, der die genaue Positionierung des Abformwerkzeuges bezüglich Markierungen auf dem Substrat, auf das abgeformt werden soll, ermöglicht. Zur Aushärtung wird das auf dem Substrat vorhandene Polymer durch das Werkzeug hindurch oder durch das Substrat hindurch mit UV-Strahlung bestrahlt und mithin ausgehärtet.

Ein mögliches Verfahren zur Bestrahlung durch das Werkzeug oder das Substrat hindurch ist aus DE10 2009 055 080 A1 bekannt.

Die zweite Prozessvariante erfolgt zumeist in einer sogenannten Step & Repeat-Maschine, die z. B. ein adaptiertes Nano-Imprint-Lithografiegerät sein kann. Dabei wird auf einem Substrat eine definierte Menge auszuhärtendes Polymer abgelegt, so dass sich ein Tropfen Polymer auf dem Substrat bildet. Anschließen wird ein Abformwerkzeug auf den Tropfen positioniert, so dass der Tropfen zum einen die Form der späteren Struktur annimmt und zum anderen mit dem Abformwerkzeug auf dem Substrat positioniert werden kann.

Anschließend erfolgt die Aushärtung des Polymers durch UV-Strahlung, wobei die UV-Strahlung beispielsweise durch ein transparent ausgestaltetes Abformwerkzeug oder durch das Substrat hindurch eine Aushärtung des Polymers bewirken kann.

Nachdem das Polymer ausgehärtet ist, wird das Abformwerkzeug entfernt und auf einen zwischenzeitlich positionierten weiteren Tropfen Polymer positioniert, um die nächste Struktur auszuformen. Auf diese Art und Weise werden nach und nach alle abzuformenden Strukturen auf dem Substrat angebracht. Ein solches Verfahren erlaubt ein beliebiges Muster der Einzelstrukturen des Abformwerkzeuges auf dem Substrat mit einer Positionsgenauigkeit von besser 1 µm.

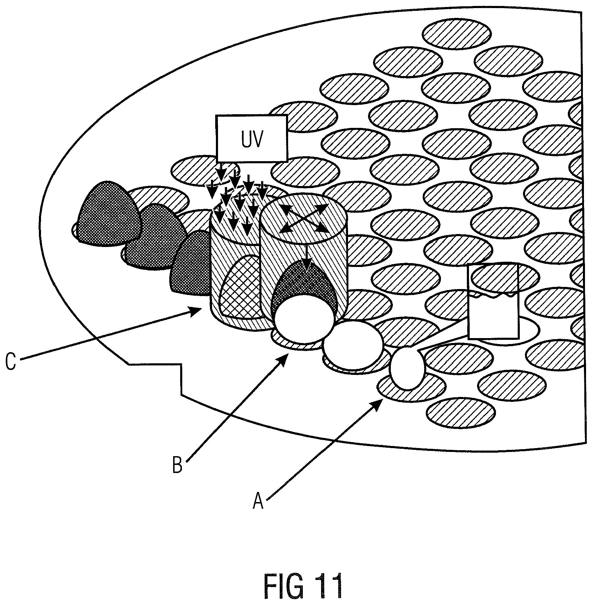

Ein möglicher Ablauf der einzelnen Prozessschritte ist in Fig. 11 dargestellt.

Sowohl während des parallelen Prozesses als auch während des sequenziellen Prozesses führt Materialschwindung während der Aushärtung des Polymers dazu, dass die durch das Abformwerkzeug vorgegebene Form der optischen Struktur, beispielsweise der Linse, nicht exakt eingehalten werden kann und so Ungenauigkeiten in der Linse auftreten oder durch die Schwindung induzierte mechanische Spannungen zu einer Verformung des Substrats führen. In der DE10 2009 055 080 A1 wird ein Verfahren erläutert, welches es gestattet, die Materialschwindung während der Aushärtung durch weiteres nachfließendes Polymer auszugleichen. Dazu wird eine lokal variierende Bestrahlung derart durchgeführt, dass eine variable Blende mit veränderlicher Aperturgröße eine veränderliche Intensität der aushärtenden Strahlung und eine veränderliche Größe der erzeugten Aushärtezone ermöglicht, so dass zuerst ein zentraler Bereich der zu bildenden Linse ausgehärtet, dort auftretende Materialschwindung durch nachfließendes Material kompensiert werden kann und anschließend die peripheren Regionen der Linse ausgehärtet werden können.

Die Festlegung der Aushärtezone erfolgt bei diesem Verfahren durch den von der variablen Blende verursachten Schattenwurf. Somit erfolgt die Aushärtung des Polymers durch eine zeitliche Steuerung der Transmissionsfunktion der eine Strahlungsquelle und eine variable Blende umfassenden Beleuchtungsoptik. Ein wesentlicher Vorteil liegt darin, dass die nicht wie bei anderen Verfahren mit einer Flutbelichtung über den gesamten Wafer gleichzeitig, sondern durch eine in ihrem Durchmesser variable Blende, wie beispielsweise eine mechanische Irisblende oder ein LCD-Display erfolgt. Trotz der größeren Konturtreue der so ausgebildeten Linsen, erlaubt dieser Prozess noch keine direkte Beobachtung des Prozessfortschrittes oder eine Beurteilung, ob ein aktiver Eingriff in den Prozess erforderlich ist. Eine weitere optische Justierung der härtenden Strahlung erfolgt in dem beschriebenen Prozess nicht.

In EP 0 322 353 A2 ist ein Konzept zur Herstellung eines Kunststoffelementes mittels eines Formwerkzeugs umfassend eine Kavität und einem Förderkanal, der mit der Kavität kommuniziert, beschrieben. Es offenbart eine Vorrichtung gemäß dem Oberbegriff des Anspruchs 1 und ein Verfahren gemäß dem Oberbegriff des Anspruchs 9.

Wünschenswert wäre demnach ein Konzept, das eine kontrollierbare Aushärtung und Abformung und damit eine Reduktion von Herstellungsausschuss ermöglicht. Die Aufgabe der vorliegenden Erfindung besteht darin, ein Konzept zu schaffen, das eine Reduktion von Herstellungsausschuss ermöglicht.

Diese Aufgabe wird durch eine Vorrichtung gemäß Anspruch 1 und ein Verfahren gemäß Anspruch 12 gelöst.

Der Kerngedanke der vorliegenden Erfindung besteht darin, erkannt zu haben, dass obige Aufgabe gelöst werden kann, wenn die aushärtende Strahlung durch die Anordnung eines strahlformenden optischen Elementes in einem optischen Kanal zwischen Strahlungsquelle und Abformwerkzeug Strahlung gebündelt wird. Dadurch ist es möglich, eine genauere Steuerung der Aushärtung des aushärtbaren Polymers zu erhalten.

Gemäß einem Ausführungsbeispiel sind zwei strahlformende optische Elemente in einem optischen Kanal angeordnet. Dabei wird ein sich in Strahlrichtung verbreitender Strahlungskegel durch ein erstes strahlformendes optisches Element zu einem Strahl mit annähernd konstanter Breite geformt und im weiteren Verlauf des Strahls durch ein zweites strahlformendes optisches Element derart gebündelt, die Intensität der Strahlung in Richtung des Abformwerkzeuges steigt. Durch die Kombination einer in Aperturgröße und/oder lateralen Position der Apertur variablen Blende mit den strahlformenden Elementen kann die das Polymer aushärtende Strahlung exakt gesteuert und somit die Exaktheit der Kontur der Linse verbessert werden.

Gemäß einem alternativen Ausführungsbeispiel ist zwischen dem ersten und dem zweiten strahlformenden Element ein strahlteilendes Element angeordnet, so dass ein Teil der von der Strahlungsquelle emittierenden Strahlung ausgekoppelt und von einer Kamera erfasst werden kann, um so eine Beobachtung der Strahlungsquelle zu ermöglichen.

Gemäß einem weiteren Ausführungsbeispiel koppelt ein strahlteilendes Element einen Teil der aus der Richtung des Formwerkzeuges zurückgeworfenen Strahlung aus und lenkt diese ebenfalls auf eine Kamera, um so die Beobachtung der Aushärtezone zu ermöglichen.

Weitere vorteilhafte Ausführungsformen sind der Gegenstand der abhängigen Patentansprüche.

Bevorzugte Ausführungsbeispiele der vorliegenden Erfindung werden nachfolgend Bezug nehmend auf die beiliegenden Zeichnungen erläutert. Es zeigen:
- Fig. 1: eine schematische Querschnittansicht einer Vorrichtung zum Aushärten aushärtbaren Materials mit einem optischen Kanal und stahlformenden Elementen;
- Fig. 2: eine schematische Querschnittansicht einer Vorrichtung mit einem optischen Kanal, strahlformenden optischen Elementen und einem strahlteilenden optischen Element und einer Kamera;
- Fig. 3: eine schematische Querschnittansicht einer Vorrichtung mit einem alternativen strahlteilenden optischen Element;
- Fig. 4: eine schematische Querschnittansicht einer Vorrichtung, bei der der optische Kanal eine variable Blende umfasst;
- Fig. 5: eine schematische Querschnittansicht einer Vorrichtung, bei der an dem Werkzeugsubstrat Blendenstrukturen und optische Mikrostrukturen angeordnet sind;
- Fig. 6a-c: eine schematische Darstellung einer variablen Blende;
- Fig. 7: eine schematische Querschnittansicht einer Vorrichtung zum lokal variierenden Bestrahlen mittels einer variablen Blende und mehrerer nebeneinander angeordneter Abformwerkzeuge;
- Fig. 8: ein Flussdiagramm eines Verfahrens zum Herstellen einer Struktur aus aushärtbarem Material;
- Fig. 9: ein Flussdiagramm eines alternativen Verfahrens zum Herstellen einer Struktur aus aushärtbarem Material;
- Fig. 10: eine schematische Querschnittansicht einer Vorrichtung zum Herstellen einer Struktur aus aushärtbarem Material;
- Fig. 11: eine Darstellung eines Abform- und Aushärteprozesses mit einer Step & Repeat-Maschine.

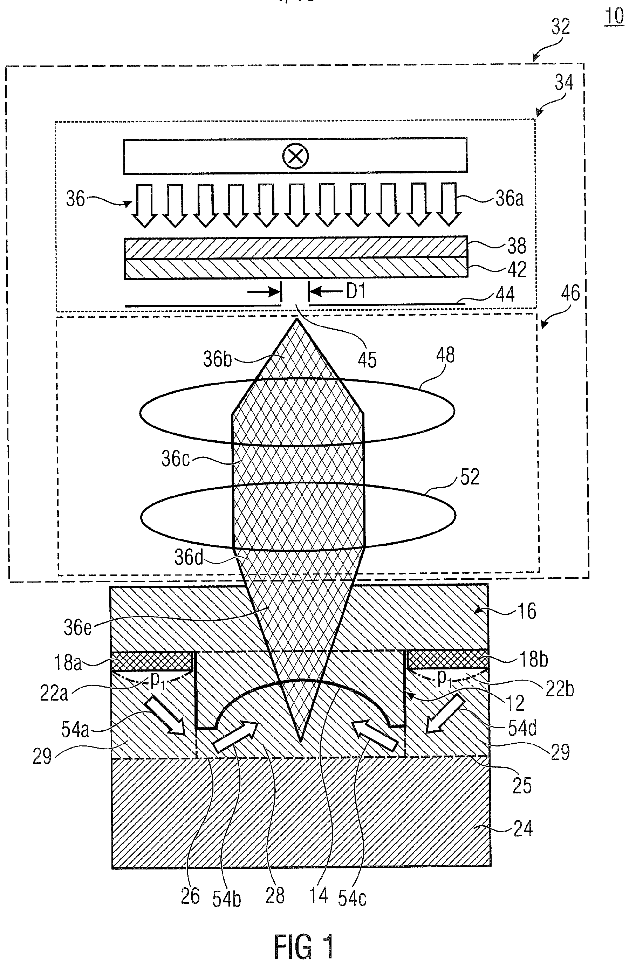

Fig. 1 zeigt eine Vorrichtung 10 mit einem Abformwerkzeug 12, welches eine Abformfläche 14 umfasst und an einem Werkzeugsubstrat 16 gebildet ist. Lateral benachbart zum Abformwerkzeug 12 sind am Werkzeugsubstrat 16 Membranschichten 18a und 18b angeordnet, die in einem Kanalbereich lose am Werkzeugsubstrat 16 anliegen und den Kanalbereich fluiddicht am Werkzeugsubstrat abschließen. Der fluiddicht abgeschlossene Kanalbereich bildet so Kanalstrukturen 22a und 22b aus. Die Abformfläche 14 kann dabei auch eine Beschichtung umfassen, die ein Anhaften von abgeformten Materialien am Abformwerkzeug 12 zu verhindern.

Das Abformwerkzeug 12 ist gegenüber einem Substrat 24 derart positioniert, dass sich zwischen einer Oberfläche 25 des Substrats 24 und dem Abformwerkzeug 12 ein Bereich 26 ausbildet, in welchem aushärtbares Material 28 angeordnet ist. Zwischen den Membranstrukturen 18a und 18b und dem Substrat befindet sich angrenzend an den Bereich 26 weiteres aushärtbares Material 29, das ausgebildet ist, um bei Anlegen eines Drucks p₁ in den Kanalstrukturen 22a und 22b einen Druck zu erfahren.

An der der Abformfläche 14 abgewandten Seite des Abformwerkzeuges 12 ist eine Bestrahlungseinheit 32 angeordnet. Sie umfasst eine Strahlungsquelle 34, die eine Strahlung 36 emittiert. Strahlen der Strahlung 36 verlaufen an ihrem Ursprung annähernd parallel zueinander. In einer Strahlungsrichtung ist ein Graufilter 38 benachbart zu und in Strahlrichtung vor einer Streuscheibe 42 angeordnet. Das Graufilter 38 ist ausgebildet, um eine eventuell zu große Intensität der Strahlung 36 abzumildern. Dahingegen ist die Streuscheibe 42 ausgebildet, um eine Kollimation der Strahlung 36 aufzuheben und die Strahlung 36 zu streuen.

Benachbart zur Streuscheibe 42 ist eine variable Blende 44 mit einer, durch einen variablen Öffnungsdurchmesser D1 ausgebildeten, variablen Abstrahlfläche 45 angeordnet. Die variable Abstrahlfläche 45 ist ausgebildet, eine durch die Streuscheibe 42 gestreute, kegelförmige Strahlung 36b mit einer, durch den variablen Öffnungsdurchmesser D1 gesteuerten, Kegelbreite aus der Strahlungsquelle 34 austreten zu lassen. Zwischen der variablen Blende 44 und dem Werkzeugsubstrat 16 ist ein optischer Kanal 46 angeordnet, der ein erstes strahlformendes optisches Element 48 und in einem weiteren Verlauf der Strahlungsrichtung ein zweites strahlformendes optisches Element 52 umfasst.

Die beiden strahlformenden optischen Elemente 48 und 52 sind dabei derart ausgebildet, dass sie einfallende Strahlung bündeln.

Dabei ist das erste strahlformende optische Element 48 derart ausgebildet und angeordnet, dass die auf das erste strahlformende optische Element 48 treffende Strahlung 36b kollimiert wird und die Strahlen der Strahlung 36b im weiteren Verlauf 36c annähernd parallel zueinander liegen. Durch den annähernd parallelen Verlauf der Strahlen im Strahlungsabschnitt 36c bleibt die Intensität der Strahlung über den Verlauf in Strahlungsrichtung annähernd konstant.

In Strahlrichtung wird die Strahlung 36c durch das zweite strahlformende optische Element 52 derart gebündelt, dass die Intensität der Strahlung im Abschnitt 36d durch die Bündelung steigt und im Bereich 26, in dem das aushärtbare Material 28 angeordnet ist, unter Vernachlässigung einer Absorption der Strahlung durch das aushärtbare Material benachbart zur Oberfläche 25 ein lokales Maximum aufweist.

Alternativ kann das lokale Maximum der Intensität der Strahlung 36 beispielsweise auch derart positioniert sein, dass es sich zwischen der Abformfläche 14 und der Oberfläche 25 befindet. Prinzipiell kann das lokale Maximum an einer beliebigen axialen Stelle positioniert sein.

Eine Schwindung des aushärtbaren Materials 28, der durch die Strahlung 36 ausgelöst wird, kann durch Anlegen eines Druckes p₁ in den Kanalbereichen 22a und 22b derart kompensiert werden, dass der Druck p₁ in den Kanalstrukturen 22a und 22b zu einem Druck in axial zu den Membranstrukturen 18a und 18b benachbarten Ausgleichsbereichen mit dem weiteren aushärtbarem Material 29 führt und ein Nachfließen 54a-d des weiteren aushärtbaren Materials 29 aus dem Ausgleichsbereich in den Bereich 26 bewirkt und durch Materialschwindung auftretende Lücken schließt. Ausgleichsbereiche, in denen das weitere aushärtbare Material 29 angeordnet ist, sind derart angeordnet, dass das weitere aushärtbare Material 29 keine Bestrahlung erfährt und mithin unausgehärtet bleibt. Hierfür wird entweder die Strahlung 36 am weiteren aushärtbaren Material 29 vorbei gelenkt oder das weitere aushärtbare Material 29 wird vor der Strahlung 36, beispielsweise durch eine Blende, abgeschirmt. Die axial zu den Membranstrukturen 18a und 18b benachbarten Ausgleichsbereiche sind dabei kein Teil optischer Funktionsbereiche der auszuhärtenden Struktur. Nach einer erfolgten Bestrahlung der auszuhärtenden Struktur kann das weitere aushärtbare Material 29 beispielsweise durch ein vollständiges Öffnen der Blende 44 ebenfalls ausgehärtet oder in einem nachfolgendem Bearbeitungsschritt entfernt werden, beispielsweise durch ein Lösungsmittel.

Durch die Anordnung der beiden strahlformenden optischen Elemente 48 und 52 ist es möglich, die in den Bereich 26 eintretende Strahlung 36 mit großer Exaktheit zu justieren. In Kombination mit der variablen Blende 44 kann die Leistung der Strahlung 36 derart genau gesteuert werden, dass die Konturtreue und mithin die Qualität abgeformter Linsen wesentlich gesteigert werden kann. Dabei ist die Blende 44 ausgebildet, dass durch die Justierung der Größe Abstrahlfläche 45 der variablen Blende 44 die laterale Ausdehnung des zu einem Zeitpunkt bestrahlten Bereichs steuerbar ist, wohingegen die strahlformenden optischen Elemente 48 und 52 ausgebildet sind, die Steuerung des Grades der Bündelung der Strahlung 36 und mithin eines Punktes mit maximaler Strahlungsintensität zu ermöglichen.

Im Abschnitt 36c können weitere optische Elemente zur Beurteilung der Strahlungsquelle und/oder zum Beobachten der Aushärtezone im Bereich 26 angeordnet sein, wie nachfolgende Ausführungsbeispiele zeigen.

Die variable Blende 44 in Kombination mit den strahlformenden optischen Elementen 48 und 52 ermöglichen eine variable Aushärtung des aushärtbaren Materials 28 entlang der Oberfläche 25 mit einer exakten Justierung der Aushärtezone durch die strahlformenden optischen Elemente 48 und 52.

Die Nutzung strahlformender Optiken erweitert die Möglichkeiten der Steuerung des Aushärteprozesses und ermöglicht eine weitere Verbesserung der Konturtreue, da das von der UV-Strahlung beleuchtete und mithin aushärtende Polymervolumen entsprechend der erzielten Strahlbeeinflussung optimal geformt werden kann. Es gestattet weiterhin die räumliche Trennung von variabler Blende und Werkzeugkontur. Im Fall der Prozeßführung mit einer Abformung vieler Strukturen zeitgleich und parallel nebeneinander durch einen Mask-Aligner sind viele gleichartige Strukturen, Werkzeuge und Strahlformungsoptiken nebeneinander angeordnet. Im Falle der sequenziellen Prozeßführung mit einer Step & Repeat-Maschine wird eine Einzelanordnung von Werkzeug und Strahlformungsoptik genutzt.

Fig. 1 zeigt einen optischen Kanal 46 mit einem aus den strahlformenden optischen Elementen 48 und 52 gebildeten zweilinsigen Strahlengang, der die Ebene der variablen Blende 44 in die Nähe der Aushärtezone und mithin in die Nähe der Substratoberfläche 25 abbildet.

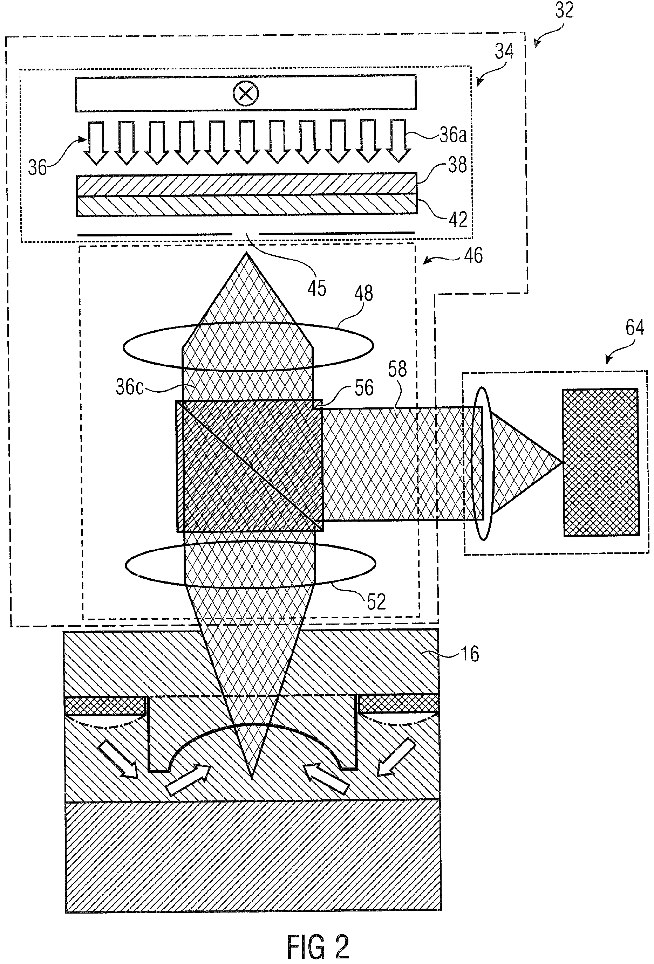

Fig. 2 zeigt Vorrichtung 10 aus Fig. 1, bei der in dem zweilinsigen Strahlengang des optischen Kanals 46 und bei der in Strahlungsrichtung zwischen dem ersten strahlformenden optischen Element 48 und dem zweiten strahlformenden optischen Element 52 ein strahlteilendes optisches Element in Form eines Strahlteilerwürfels 56 angeordnet ist.

Der Strahlteilerwürfel 56 ist ausgebildet, um einen Teil der Strahlung 36c auszukoppeln und so angeordnet, dass ein ausgekoppelter Anteil 58 auf eine Bildfläche einer Kamera 64 gelenkt wird. Die Kamera 64 ist ausgebildet, um eine Beobachtung und Auswertung der emittierten Strahlung 36 zu ermöglichen. Die Auswertung kann beispielsweise die Form des Strahls im Abschnitt 36b oder den Grad der Streuung der Strahlung durch die Streuscheibe 42 betreffen. Auch ist denkbar, dass die Intensität der Strahlung 36 auf diese Art und Weise überwacht werden kann.

Obwohl in Fig. 2 das strahlteilende optische Element 56 in Form eines Strahlteilerwürfels dargestellt ist, ist es ebenfalls denkbar, dass ein anders ausgeformtes strahlteilendes optisches Element verwendet wird, wie beispielsweise ein Pelikel oder ein Strahlteilerblättchen, um einen Teil der Strahlung seitlich auszukoppeln.

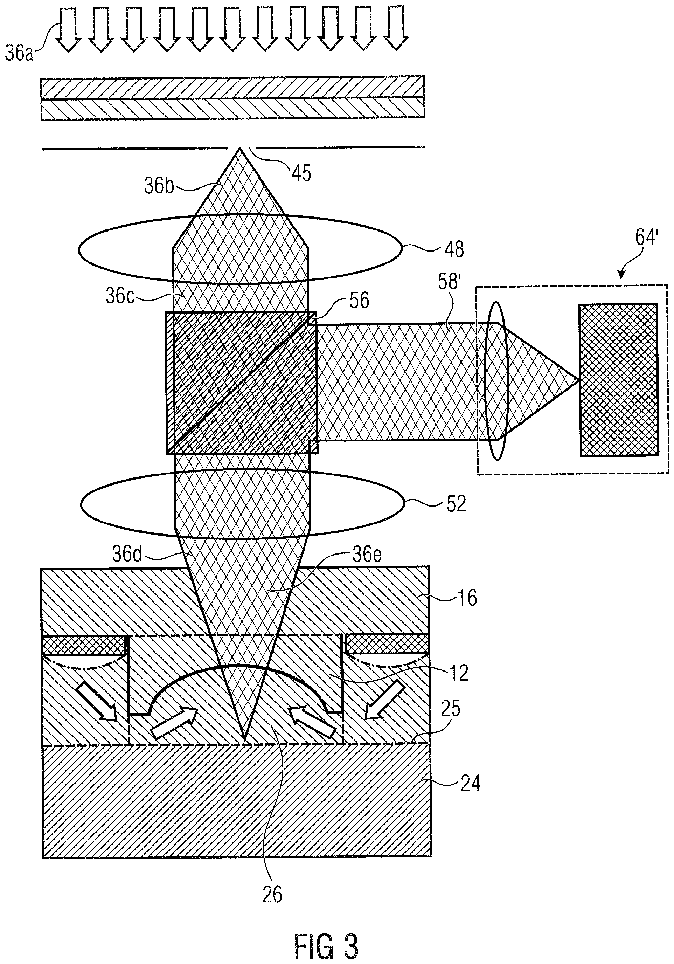

Fig. 3 zeigt eine Vorrichtung analog Vorrichtung 10 in Fig. 2, bei der der Strahlteilerwürfel 56 derart angeordnet ist, dass ein Teil einer von dem Abformwerkzeug oder der Aushärtezone zurückgeworfenen Strahlung ausgekoppelten und der ausgekoppelte Anteil 58' der zurückgeworfenen Strahlung auf die Bildfläche der Kamera 64' gelenkt wird, um eine Beobachtung der Aushärtezone zu ermöglichen.

Obwohl in Fig. 3 das strahlteilende optische Element 56 als Strahlteilerwürfel dargestellt ist, ist analog Fig. 2 auch eine andere Ausbildungsform des strahlteilenden Elementes, beispielsweise als Pelikel oder als Strahlteilerblättchen, denkbar.

Werden die Ausführungsbeispiele der Fig. 2 und 3 kombiniert, so ist vorstellbar, dass eine Beobachtung und Auswertung der Strahlungsquelle in Kombination mit einer Beobachtung und Auswertung der Aushärtezone ein Steuer- oder Regelkreis aufgebaut wird, dass die den optischen Kanal durchquerende Strahlung derart durch die Strahlungsquelle, die variable Blende oder die strahlformenden optischen Elemente beeinflusst wird, dass die Aushärtung in einer gewünschten Art und Weise optimiert wird. So kann beispielsweise eine beobachtete zu rasche Aushärtung durch einen stärker dämpfenden Graufilter 38 ausgeglichen werden, so dass die Strahlungsintensität reduziert und damit die Aushärtung verlangsamt wird. Eingriffe in den Aushärteprozess, wie bspw. eine Justierung der Strahlungsintensität, können über eine automatisierte Steuerung oder Regelung erfolgen, über die eine Auswertung der Strahlungsquelle und/oder der Aushärtezone erfolgt. Alternativ oder zusätzlich kann eine Beobachtung und/oder Auswertung der Strahlungsquelle und/oder der Aushärtezone sowie der Eingriff in den Aushärteprozess manuell durch einen Bediener erfolgen.

Dies kann dabei in einem laufenden Prozess erfolgen, so dass Materialausschüsse durch eventuelle Fehlproduktionen vermindert werden können.

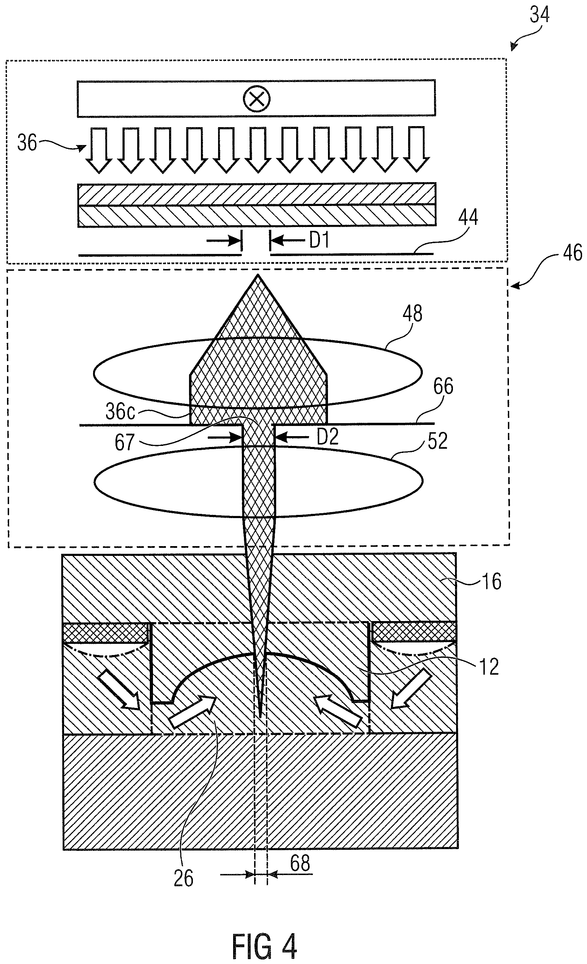

Obwohl in Fig. 3 und Fig. 4 eine Kamera zur Beobachtung der Aushärtungszone respektive der Strahlungsquelle dargestellt ist, sind auch andere Arten von Bildsensoren möglich, beispielsweise ein Intensitätsmesser.

Fig. 4 zeigt Vorrichtung 10, bei der in Strahlungsrichtung zwischen dem ersten strahlformenden optischen Element 48 und dem zweiten strahlformenden optischen Element 52 eine weitere variable Blende 66 angeordnet ist. Die weitere variable Blende 66 umfasst eine in Größe und lateraler Position variable Apertur 67 mit dem variablen Durchmesser D2. Durch den annähernd parallelen Verlauf der Strahlen der Strahlung 36 im Abschnitt 36c ist eine lineare Skalierung der in Strahlungsrichtung weiterhin von der Strahlung 36 umfassten Strahlungsleistung durch die variable Apertur 67 möglich.

Die variable Blende 66 ist zudem ausgebildet, die laterale Ausdehnung 68, in welcher der Bereich 26 von der Strahlung 36 bestrahlt wird, präzise zu justieren, da der bestrahlte Bereich lateral sehr präzise aufgelöst werden kann.

Es ist denkbar, dass die in Fig. 4 beschriebene weitere variable Blende 66 in den vorangehend beschriebenen Steuer-Regelungskreis integriert ist. Dadurch sind weitere Optimierungen des Herstellungsprozesses vorstellbar.

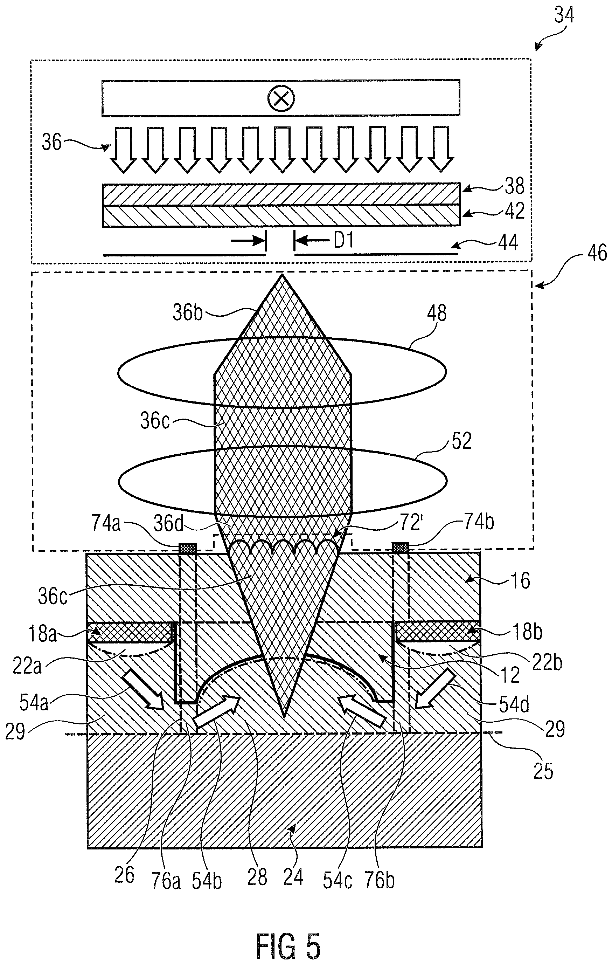

Fig. 5 zeigt eine Vorrichtung 10 analog Fig. 1 mit einem zweilinsigen Strahlengang, bei der am Substrat des Abformwerkzeuges Mikrostrukturen 72 zur lokalen Einstellung der Divergenz der Beleuchtung und Blendenstrukturen 74a und 74b zur Abschirmung von Bereichen 76a und 76b vor Bestrahlung angeordnet sind.

Eine stark gerichtete Bestrahlung des aushärtbaren Materials 28 kann zur Bildung von Brechzahlgradienten im aushärtbaren Material 28 führen, was zu Schlieren und mithin verschlechterter optischer Funktion des ausgehärteten Materials führen kann. Eine Vermeidung der Schlierenbildung kann daher durch eine diffuse Bestrahlung erreicht werden. Die Nutzung der lokalen Mikrostrukturen 72 ermöglicht die Diffusion eintreffender Strahlung und führt damit zur lokal erhöhter Divergenz der Strahlung, was die Ausbildung von Schlieren vermeidet. Das von der Optik transmittierte Licht kann so lokal gestreut und die Richtungswirkung der vorgeschalteten Optik teilweise oder gänzlich aufgehoben werden.

Anstelle der gezeigten Mikrolinsen 72 können zur Diffusion der eintretenden Strahlung auch diffraktive Elemente, Oberflächen- oder Volumendiffusoren am Werkzeugsubstrat angeordnet sein. Diese Elemente können ebenso wie die Mikrolinsen ein- oder beidseitig, durchgängig oder diskontinuierlich ausgebildet sein und auf einer oder mehreren Seiten des Werkzeuges oder des Werkzeugsubstrates angeordnet sein. Auch können die Elemente zur lokalen Diffusion am Substrat angeordnet sein, um Strahlung, die durch das Substrat hindurch auf das aushärtbare Material trifft, lokal zu divergieren.

Die Blendenstrukturen 74a und 74b dienen zur Abschirmung von Bereichen 76a und 76b, welche während einer Bestrahlung durch das Abformwerkzeug 12 respektive des Werkzeugsubstrates 16 oder die Membranstrukturen 18a, 18b hindurch nicht ausgehärtet werden sollen. Die Blendenstrukturen 74a und 74b schirmen die Strahlung 36 derart ab, dass die kanalartigen Schatten 76a und 76b ausgebildet werden. In den Bereichen der Schatten 76a und 76b bleibt das aushärtbare Material 28 oder das weitere aushärtbare Material 29 während einer Bestrahlung unausgehärtet. Nach einem, der Aushärtung folgendem, Reinigungs- oder Entwicklungsvorgang ist in diesen Bereichen kein ausgehärtetes Material angeordnet. Diese Bereiche können dann beispielsweise zum Eingeben eines Lösungsmittels oder zum Lösen von löslichem aushärtbaren Material, um Lufträume zu erzeugen, genutzt werden.

Die Anordnung von Mikrostrukturen oder Blendenstrukturen erweitert den Anwendungsbereich strahlformender Vorrichtungen dahin gehend, dass zusätzliche Freiheitsgrade bezüglich der Ausgestaltung sowie eine erhöhte Qualität der abgeformten Strukturen erzielbar sind.

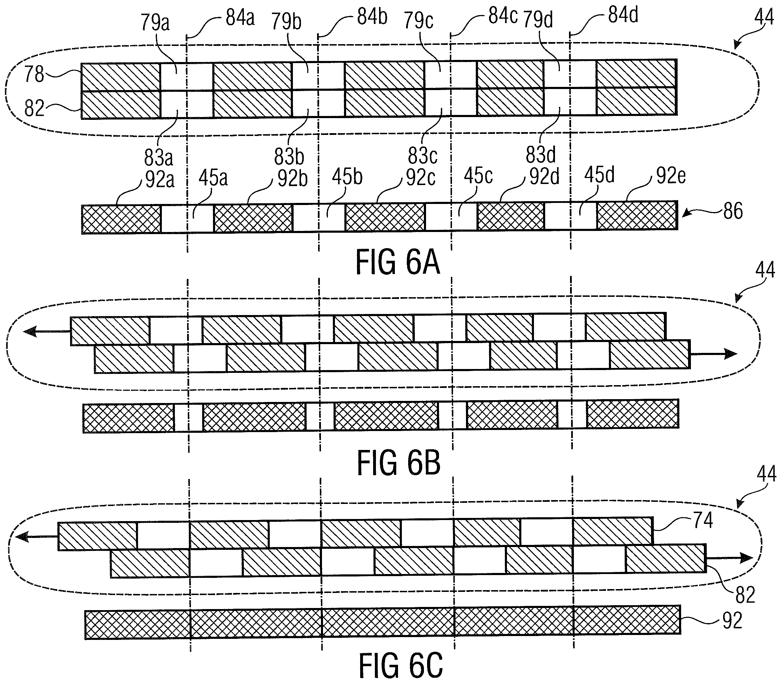

Die Fig. 6a-c zeigen schematische Darstellungen einer Umsetzung einer variablen Blende 44. In Fig. 6a ist eine erste Blende 78 mit mehreren Aperturen 79a-d gegenüber einer zweiten Blende 82 mit mehreren Aperturen 83a-d derart angeordnet, dass die Aperturen 79a-d und 83a-d gemeinsame optische Achsen 84a-d umfassen. Die erste Blende 78 und die zweite Blende 82 sind identisch ausgebildet. Durch ihre benachbarte Anordnung zueinander bilden die erste Blende 78 und die zweite Blende 82 eine gemeinsame effektive Blende 86.

Die effektive Blende 86 umfasst dabei variablen Durchlassbereiche 45a-d und die effektiven Schattenbereiche 92a-e.

Fig. 6b stellt den Effekt auf die effektive Blende 86 bei einer Verschiebung der ersten Blende 78 und der zweiten Blende 82 gegeneinander um die optischen Achsen 84a-d dar. Wird die Blende 78 lateral zu den optischen Achsen 84a-d in eine Richtung und die zweite Blende 82 ebenfalls lateral in eine entgegengesetzte Richtung verschoben, so ergeben sich gegenüber Fig. 6a verkleinerte variable Durchlassbereiche 45a-d und vergrößerte variable Schattenbereiche 92a-e der effektiven Blende 86, wobei jedoch die Mitten der jeweiligen Durchlassbereiche und damit die optischen Achsen ortsfest verbleiben.

Fig. 6c zeigt, dass eine Verschiebung der ersten Blende 78 und der zweiten Blende 82 gegeneinander in entgegengesetzte Richtungen lateral zu den optischen Achsen 84a-d so weit geführt werden kann, dass der gesamte Bereich der effektiven Blende 86 den Schattenbereich 92 aufweist und die variablen Durchlassbereiche 45 eine Größe von Null aufweisen.

Der Abstand der Aperturen 79a-d respektive der Aperturen 83a-d entspricht bei Herstellung einer Mehrzahl bzw. eines Feldes von Strukturen dem Einfachen oder Mehrfachen des Abstandes der herzustellenden Strukturen bzw. Linsen. Die Aperturen 79 und 83 können dabei z. B. einfache rechteckige oder runde Öffnungen aufweisen.

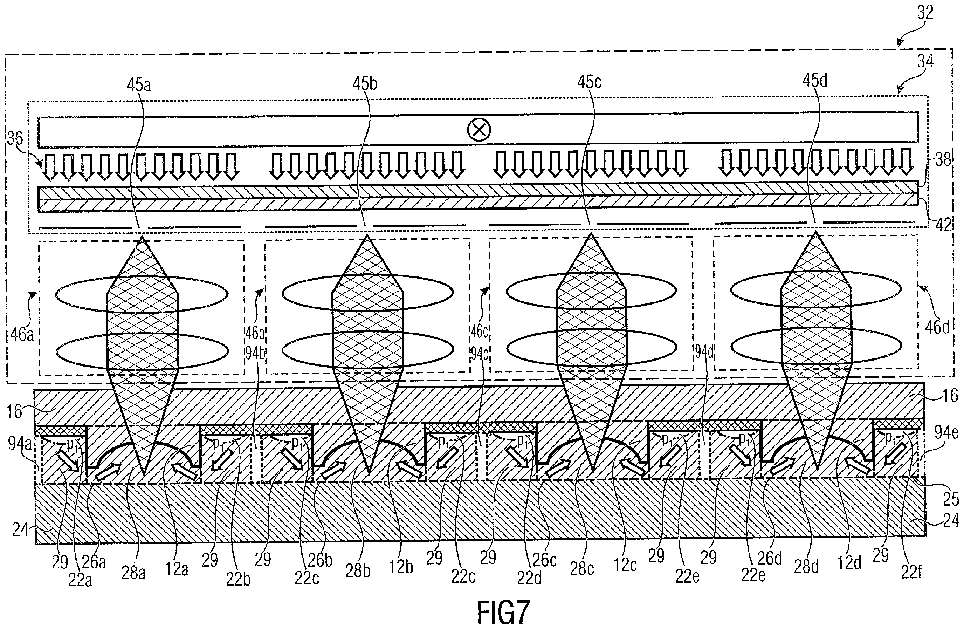

Fig. 7 zeigt eine Vorrichtung 20, die vier Abformwerkzeuge 12a-d umfasst. Die Strahlungsquelle 34 ist ausgebildet, um die Strahlung 36 bereitzustellen. Benachbart zu jedem Aushärtebereich 26a-d ist analog Vorrichtung 10 je ein optischer Kanal 46a-d angeordnet. Die variable Blende 44 weist axial benachbart zu den vier optischen Kanälen 46a-d je eine variable Abstrahlfläche 45a-d auf. Das variable Graufilter 38 und die Streuscheibe 42 sind ausgebildet, um die Strahlung 36 simultan für jeden der vier optischen Kanäle 46a-d zu filtern und zu streuen. Die Streuscheibe 42 ist ausgebildet, um eintreffende Strahlung 36 derart zu streuen, dass in jeden der vier optischen Kanäle 46a-d eine gestreute Strahlung eintritt.

Die am Werkzeugsubstrat 16 angeordneten Kanalstrukturen 22a-f sind untereinander fluidisch verbunden. Die fluidische Verbindung der Kanalstrukturen 22a-f führt dazu, dass ein Anlegen eines Druckes p₁ in einer der Kanalstrukturen 22a-f auch zu einer Ausbildung des Druckes p₁ in den fluidisch verbundenen weiteren Kanalstrukturen führt.

Die Abformwerkzeuge 12a-d sind an dem gemeinsamen Werkzeugsubstrat 16 angeordnet. Dahingegen sind die Abformwerkzeuge 12a-d ausgebildet, um die Bereiche 26a-d auf dem Substrat 24 mit der Oberfläche 25 abzuformen.

Obwohl in Fig. 7 die Abformwerkzeuge an einem gemeinsamen Werkzeugsubstrat angeordnet sind und die Bereiche 26a-d an der Oberfläche des gemeinsamen Substrates abgeformt werden, ist es ebenfalls möglich, dass das Werkzeugsubstrat und/oder das Substrat aus mehreren Einzelkomponenten gebildet sind.

Lateral benachbart zu den sowie zwischen je zwei Ausgleichsbereichen, in denen das weitere aushärtbare Material 29 angeordnet ist, ist ausgehärtetes Material 94a-e angeordnet, welches die Bereiche 26a-d derart von einander separiert, dass weiteres aushärtbares Material 29 lediglich in einen lateral benachbarten Bereich 26a-d, nicht jedoch in einen anderen Ausgleichsbereich fließen kann. Das ausgehärtete Material 94a-e kann beispielsweise derart angeordnet werden, dass zwischen einem Schritt eines Anordnens von aushärtbarem und weiterem aushärtbarem Material 28 und 29 und eines Bestrahlens der Bereiche 26a-d das weitere aushärtbare Material in bezüglich der Bereiche 26a-d lateral außen liegenden Randbereichen der Ausgleichsbereiche das weitere aushärtbare Material 29 ausgehärtet wird.

Die axial zu mehreren optischen Kanälen angeordnete und deswegen großflächige ausgeformte Strahlungsquelle 34 ist derart ausgebildet, um im axial zu den optischen Kanälen 46a-d benachbarten Bereich eine kollimierte Strahlung zu emittieren. Die Streuscheibe 42 ist dahingegen ausgebildet, um die Kollimation aufzuheben und bezüglich der variablen Abstrahlflächen 45a-d und der in Strahlrichtung nachfolgend angeordneten optischen Kanäle 46a-d jeweils wie eine punktförmige Strahlungsquelle zu wirken.

Obwohl in vorangegangenen Ausführungsbeispielen ein optischer Kanal jeweils zwei strahlformende optische Elemente umfasst, ist es ebenfalls denkbar, dass lediglich ein strahlformendes optisches Element oder aber mehrere strahlformende optische Elemente von einem optischen Kanal umfasst werden.

Obwohl die strahlformenden optischen Elemente 48 und 52 in vorangegangenen Ausführungsbeispielen als Linse dargestellt werden, ist es ebenfalls denkbar, dass optischer Kanal ein oder mehrere andere strahlformenden optischen Elemente umfasst, beispielsweise ein Prisma, eine diffraktive Struktur oder eine Fresnel-Linse. Die strahl formenden optischen Elemente können gleich oder verschieden von einander ausgebildet sein, auch können optische Kanäle von einander sich dahingehend unterscheiden, dass unterschiedliche optische Kanäle unterschiedliche strahlformende optische Elemente umfassen. Weiterhin ist denkbar, dass im Falle einer Ausführung analog Fig. 7 mit mehreren optischen Kanälen, nur einige optische Kanäle strahlteilende optische Elemente umfassen um einen Steuer- oder Regelkreis zu realisieren. Prinzipiell kann jeder optische Kanal unabhängig von anderen optischen Kanälen realisiert sein.

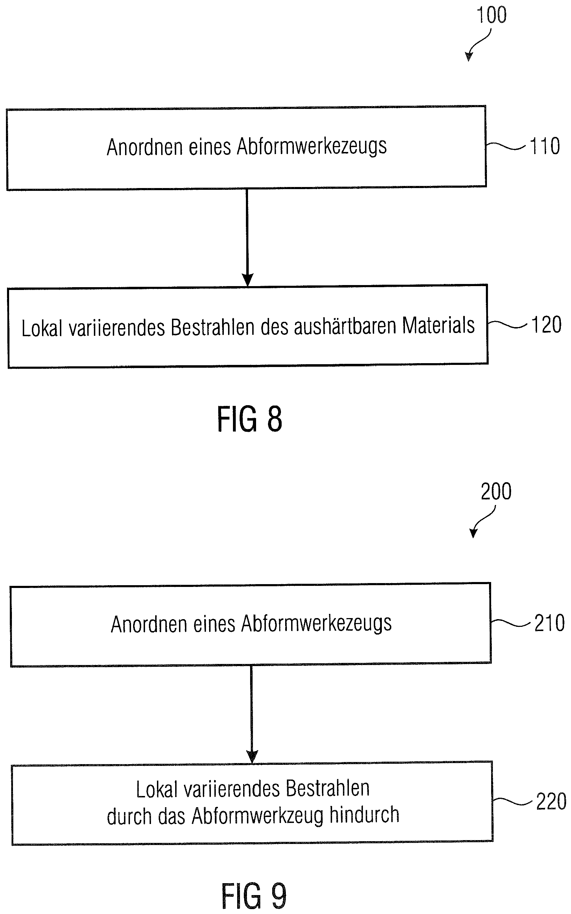

Fig. 8 zeigt ein Flussdiagramm eines Verfahrens 100 gemäß einem Ausführungsbeispiel der vorliegenden Erfindung. Das Verfahren 100 zum Herstellen einer Struktur aus aushärtbarem Material durch Abformung umfasst einen ersten Schritt 110 des Anordnens eines Abformwerkzeuges 12 oberhalb einer Oberfläche 25, beispielsweise einem Glassubstrat, so dass in einem Bereich 26 zwischen dem Abformwerkzeug 12 und der Oberfläche 25 das aushärtbare Material 28, beispielsweise ein UV-Polymer, an der Oberfläche 25 und eine der Oberfläche 25 zugewandten Abformfläche 14 des Abformwerkzeuges 12 angrenzt und so dass weiteres aushärtbares Material 29 in den Bereich 26 nachfließen kann. Weiterhin umfasst das Verfahren 100 einen zweiten Schritt 120 des lokal variierenden Bestrahlens des aushärtbaren Materials 28 mittels eines Strahls 36, der einen zwischen einer Strahlungsquelle 34 und dem Abformwerkzeug 12 angeordneten optischen Kanal 46 durchquert und während der Durchquerung eine Strahlbündelung erfährt, in dem Bereich, so dass das aushärtbare Material 28 lateral entlang der Oberfläche 25 unterschiedlich schnell aushärtet und Schwindungen beim Aushärten des aushärtbaren Materials 28 durch das weitere aushärtbare Material 29 ausgeglichen werden.

Ein Nachfließen des weiteren aushärtbaren Materials 29 in den Bereich 26 kann dabei beispielsweise durch Aufbringen des Druckes p₁ in den Kanalstrukturen 22a und 22b und mithin dem Aufbringen eines Druckes an dem weiteren aushärtbaren Material 29 induziert werden. Alternativ oder zusätzlich ist denkbar, dass das weitere aushärtbare Material 29 von einer lateralen Seite aus mit einem Druck beaufschlagt wird, um ein Nachfließen des weiteren aushärtbaren Materials 29 in den Bereich 26 zu bewirken. Wird der Druck p₁ während des Bestrahlens angelegt, so fließt das weitere aushärtbare Material 29 während der Schwindung in den Bereich 26 nach.
Fig. 9 zeigt ein Flussdiagramm eines Verfahrens 200 gemäß einem Ausführungsbeispiel der vorliegenden Erfindung. Das Verfahren 200 zum Herstellen einer Struktur aus aushärtbarem Material durch Abformung umfasst einen ersten Schritt 210 des Anordnens eines Abformwerkezeuges 12 oberhalb einer Oberfläche 25, beispielsweise einem Glassubstrat, so dass in einem Bereich 26 zwischen dem Abformwerkzeug 12 und der Oberfläche 25 das aushärtbare Material 28 an die Oberfläche 25 und eine der Oberfläche zugewandten Abformfläche 14 des Abformwerkzeuges 12 angrenzt und so dass weiteres aushärtbares Material 29 in den Bereich 26 nachfließen kann. Weiterhin umfasst das Verfahren 200 einen zweiten Schritt 220 des lokal variierenden Bestrahlens des aushärtbaren Materials 28 mittels eines Strahls 36, der einen zwischen der Strahlungsquelle 34 und dem Abformwerkzeug 12 angeordneten optischen Kanal 46 durchquert und während der Durchquerung eine Strahlbündelung erfährt, in dem Bereich, so dass das aushärtbare Material 28 lateral entlang der Oberfläche 25 unterschiedlich schnell aushärtet, und Schwindungen beim Aushärten des aushärtbaren Materials 28 durch das weitere aushärtbare Material 29 ausgeglichen werden, wobei das lokal variierende Bestrahlen von einer der Abformoberfläche 14 abgewandten Seite des Abformwerkzeuges 12 durch das Abformwerkzeug 12 hindurch durchgeführt wird.

Durch die Kompensation der Volumenschwindung des aushärtbaren Materials während der Aushärtung können präzisere Abformungen von optischen und mechanischen Komponenten, insbesondere für große Strukturhöhen von mehreren hundert Mikrometern, erzielt werden. Dies ist Voraussetzung für die Fertigung mikroskopischer und mikromechanischer Komponenten, wie sie vor allem in der Fertigung für abbildende Systeme auf Waferlevel benötigt werden. Weiterhin kann mechanische Spannung, die ebenfalls durch den Schwindungsprozess bedingt ist, reduziert werden. Infolgedessen kann ein Durchbiegen des Substrates, bspw. eines Wafers, reduziert und derartige Wafer zu komplexeren Stapeln verarbeitet werden, wie dies unter anderem in der Fertigung von Kameramodulen auf Waferlevel erforderlich ist. Die Nutzung strahlformender Optiken erweitern die Möglichkeiten der Steuerung des Aushärteprozesses und ermöglichen eine weitere Verbesserung der Konturtreue.

In anderen Worten dient eine Verbesserung des Aushärteprozesses unter anderem einer optimierten Herstellung mikrooptisch-elektromechanischer Systeme (MOEMS) durch Replikationsprozesse, wie z. B. Waferlevel-Fertigung von Kameraobjektiven und optischen Sensoren.

Zusätzlich zur zeitlich-räumlich gesteuerten Beleuchtung des aushärtbaren Materials mit UV-Strahlung unter gleichzeitiger Beaufschlagung des weiteren aushärtbaren Materials unter mit Druck unter Nutzung flexibler, in das Werkzeug integrierter Membranstrukturen zur Schwindungskompensation sind pro auszuhärtender Struktur optische Elemente angeordnet, die eine Strahlformung der aushärtenden UV-Strahlung ermöglichen.

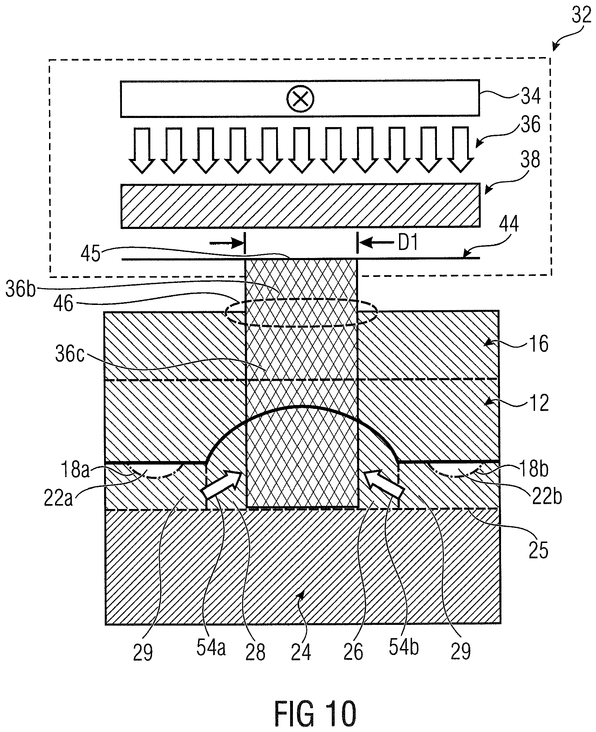

Fig. 10 zeigt eine Vorrichtung zum lokal variierenden Bestrahlen, gemäß dem Stand der Technik. Die Vorrichtung umfasst die Bestrahlungseinheit 32 und das Formwerkzeug 12, welches am Werkzeugsubstrat 16 angeordnet ist. Zwischen dem Substrat 24 und dem Formwerkzeug 12 ist das aushärtbare Material 28 angeordnet, wobei das Formwerkzeug gegenüber der, dem Formwerkzeug 12 zugewandten, Oberfläche 25 des Substrates 24 derart angeordnet ist, dass während einer Bestrahlung auftretender Schrumpf im aushärtbaren Material 28 durch das Nachfließen 54a und 54b des weiteren aushärtbaren Materials 29 ausgeglichen werden kann.

Gegenüber den vorangegangenen Ausführungsbeispielen, die sich auf eine Weiterentwicklung des Standes der Technik beziehen, umfasst der optische Kanal 46 zwischen der Bestrahlungseinheit 32 und dem Substrat des Abformwerkzeuges 16 keine strahlformenden optischen Elemente. Die variable Blende 44 und die variable Abstrahlfläche 45 mit dem Durchmesser D1 sind ausgebildet, um die Strahlung 36 begrenzen und somit ein lokal variierendes Bestrahlen zu ermöglichen. Diese Anordnung ermöglicht jedoch keine Fokussierung der Strahlung 36 in der Aushärtezone oder eine Abbildung der Strahlung 36 oder der Aushärtezone im Bereich 26 auf eine Kamera.

Im Gegensatz zu den vorangegangenen Ausführungsbeispielen sind die Membranstrukturen 18a und 18b direkt am Formwerkzeug 12 angeordnet. Die Ausbildung der Membranstrukturen 18a und 18b sowie der Kanalstrukturen 22a und 22b und mithin deren Funktion bezüglich einer Aufbringung externen Druckes auf das weitere aushärtbare Material 29 ist jedoch identisch.

Ein wesentlicher Vorteil der vorangegangenen Ausführungsbeispiele gegenüber dem in Fig. 10 dargestellten Stand der Technik ist die Integration strahlformender optischer Elemente in den optischen Kanal, so dass zum einen eine Fokussierung der Strahlung in der Aushärtezone möglich ist und zum anderen auf oben beschriebene Art und Weise eine Steuerung respektive eine Regelung des Aushärungsprozesses umgesetzt werden kann.

Fig. 11 zeigt einen beispielhaften Ablauf eines sequentiellen Abform- und Aushärtungsprozesses in einer Step & Repeat-Maschine, die z. B. ein adaptiertes Nano-Imprint-Lithografiegerät sein kann. In einem ersten Schritt A wird auf dem Substrat eine definierte Menge auszuhärtendes Polymer abgelegt, so dass sich ein Tropfen Polymer auf dem Substrat bildet. Anschließen wird in einem Schritt B ein Abformwerkzeug auf den Tropfen positioniert, so dass der Tropfen zum einen die Form der späteren Linse annimmt und zum anderen mit dem Abformwerkzeug auf dem Substrat positioniert werden kann.

Anschließend erfolgt in einem Schritt C die Aushärtung des Polymers durch UV-Strahlung, wobei die UV-Strahlung beispielsweise durch ein transparent ausgestaltetes Abformwerkzeug oder durch das Substrat hindurch eine Aushärtung des Polymers bewirken kann.

Nachdem das Polymer ausgehärtet ist, wird das Abformwerkzeug entfernt und auf einen zwischenzeitlich positionierten weiteren Tropfen Polymer positioniert, um die nächste Linse auszuformen. Auf diese Art und Weise werden nach und nach alle abzuformenden Linsen auf dem Substrat angebracht.

Gemäß vorangehend beschriebenen Ausführungsbeispielen kann das strahlteilende optische Element in Strahlrichtung hinter dem zumindest ersten strahlformenden optischen Element angeordnet sein.

Gemäß vorangehend beschriebenen Ausführungsbeispielen kann das strahlteilende optische Element in Strahlrichtung vor dem zumindest ersten strahlformenden optischen Element angeordnet sein.

Gemäß vorangehend beschriebenen Ausführungsbeispielen kann in einer Strahlrichtung zwischen dem ersten und dem zweiten strahlformenden optischen Element eine in Aperturgröße und/oder lateraler Position variable Apperturblende angeordnet sein.

Gemäß vorangehend beschriebenen Ausführungsbeispielen kann das lokal variierende Bestrahlen derart durchgeführt werden, dass weiteres aushärtbares Material aus einem Ausgleichsbereich des Abformwerkzeugs in den Bereich nachfließt, der von einer Strahlung, mit der das Bestrahlen erfolgt, nicht erreicht wird.

## Patentansprüche

1. Vorrichtung zum Herstellen einer Struktur aus aushärtbarem Material durch Abformung, mit folgenden Merkmalen:
einem Abformwerkzeug (12) mit einer Abformfläche (14);
einer Einrichtung zum Anordnen des Abformwerkzeugs (14) oberhalb einer Oberfläche (25) so dass das aushärtbare Material (28) in einen Bereich zwischen der Oberfläche (25) und der der Oberfläche (25) zugewandten Abformfläche (14) des Abformwerkzeugs (12) angrenzt und so dass weiteres aushärtbares Material (29) in den Bereich (26) nachfließen kann;
einem Bildsensor (64'); und
einer Bestrahlungseinheit (32) mit einer Strahlungsquelle (34) und einem optischen Kanal (46); wobei
die Bestrahlungseinheit (32) ausgebildet ist, um eine lokal variierende Bestrahlung des aushärtbaren Materials (28) in dem Bereich (26) so durchzuführen, dass das aushärtbare Material (28) lateral entlang der Oberfläche (25) variierend unterschiedlich schnell aushärtet, und Schwindungen beim Aushärten des aushärtbaren Materials (28) durch das weitere aushärtbare Material (29) ausgeglichen werden;
wobei der optische Kanal (46) zumindest ein erstes optisches Element (48;52) zur Strahlformung einer von der Strahlungsquelle (34) emittierten Strahlung (36) aufweist, so dass die Strahlung (36) bei einer Durchquerung des optischen Kanals (46) in Richtung des Abformwerkzeugs (12) eine Strahlungsbündelung erfährt;
**dadurch gekennzeichnet, dass** der optische Kanal (46) ein strahlteilendes Element (56) umfasst, das ausgebildet ist, einen Teil einer von dem Abformwerkzeug (12) zurückgeworfenen Strahlung auszukoppeln und den ausgekoppelten Teil (58') auf einen Bildsensor (64') abzubilden.

2. Vorrichtung gemäß Anspruch 1, bei der die zurückgeworfene Strahlung basierend auf der den optischen Kanal durchquerenden Strahlung (36) von dem Abformwerkzeug zurückgeworfen wird.

3. Vorrichtung gemäß Anspruch 1 oder 2,
wobei die Strahlungsquelle (34) eine variierbare Abstrahlfläche (45) aufweist und die Vorrichtung einen weiteren Bildsensor (64) aufweist, wobei
der optische Kanal (46) ein strahlteilendes Element (56) umfasst, das ausgebildet ist, einen Teil der von der Strahlungsquelle (34) emittierten Strahlung (36) auszukoppeln und den ausgekoppelten Teil (58) auf eine Projektions- oder Bildfläche zu lenken, so dass die Abstrahlfläche (45) auf den weiteren Bildsensor (64) abgebildet wird.

4. Vorrichtung nach einem der Ansprüche 1-3,
bei der der optische Kanal (46) ein erstes und ein zweites strahlformendes Element (48; 52) umfasst und die die Strahlung (36) der Strahlungsquelle (34) kollimiert und anschließend fokussiert wird.

5. Vorrichtung gemäß einem der vorangehenden Ansprüche, mit:
einer Struktur zur Strahldiffusion (72), welche zwischen der Strahlungsquelle (36) und der Abformfläche (14) angeordnet ist.

6. Vorrichtung gemäß einem der vorangegangenen Ansprüche, wobei:
die Vorrichtung ausgebildet ist, um eine Mehrzahl von Strukturen gleichzeitig herzustellen, die Bestrahlungseinheit (32) einen optischen Kanal (46a-d) und die Abformwerkzeuge (12a-d) eine Abformfläche (14a-d) pro herzustellender Struktur aufweisen,
die Strahlungsquelle (34) einen gemeinsamen Strahlungsemitter, ein optisches Element zur Strahlstreuung (42) und eine variierbare Blendeneinheit (44) mit fixen Einzelblenden aufweist, wobei ein Abstand der Einzelblenden einem Abstand der herzustellenden Strukturen entspricht und das optische Element zur Strahlstreuung (42) und die variierbare Blendeneinheit (44) in Strahlrichtung so hinter dem Strahlungsemitter angeordnet sind, dass pro herzustellender Struktur diffuse Strahlung die variable Blendeneinheit durch eine variierbare Abstrahlfläche (45a-d) verlässt und durch einen jeweiligen optischen Kanal (46a-d) zum aushärtbaren Material (28a-d) gelenkt wird.

7. Vorrichtung gemäß einem der vorangegangenen Ansprüche, mit
einer benachbart zur Abformfläche (14) angeordneten Membranschicht (18a; 18b), wobei die Membranschicht in einem Kanalbereich eines Werkzeugsubstrates (16), der zur Abformfläche (14) lateral benachbart ist, an dem Werkzeugsubstrat (16) lose anliegt und um den Kanalbereich fluiddicht mit dem Werkzeugsubstrat (16) verbunden ist, so dass ein Bereich zwischen dem Werkzeugsubstrat (16) und der Innenseite der Membranschicht (18a; 18b) eine ausdehnbare Kanalstruktur (22a; 22b) bildet; und
die ausdehnbare Kanalstruktur (22a; 22b) so ausgebildet ist, dass ein Anlegen eines externen Drucks (p₁) in der ausdehnbaren Kanalstruktur (22a; 22b) einen Druck in dem weiteren aushärtbaren Material (29) induziert.

8. Vorrichtung gemäß Anspruch 7, ferner umfassend ein weiteres Abformwerkzeug (12a-d) zur Herstellung einer weiteren Struktur;
wobei die ausdehnbaren Kanalstrukturen (22a; 22b) des Abformwerkzeugs (12a) mit den ausdehnbaren Kanalstrukturen (22c-f) des weiteren Abformwerkzeugs (12b-d) fluidisch verbunden sind; und
wobei die ausdehnbaren Kanalstrukturen (22a-f) ausgebildet sind, dass das Anlegen des externen Drucks (p₁) in den ausdehnbaren Kanalstrukturen (22a-f) einen Druck an dem weiteren aushärtbaren Material (29) induziert.

9. Verfahren zum Herstellen einer Struktur aus aushärtbarem Material (28) durch Abformung, wobei das Verfahren folgende Schritte aufweist:
Anordnen eines Abformwerkzeugs (12) oberhalb einer Oberfläche (25), so dass in einem Bereich (26) zwischen dem Abformwerkzeug (12) und der Oberfläche (25) das aushärtbare Material (28) an die Oberfläche (25) und eine der Oberfläche (25) zugewandten Abformfläche (14) des Abformwerkzeugs (12) angrenzt und, so dass weiteres aushärtbares Material (29) in den Bereich (26) nachfließen kann;
Lokal variierendes Bestrahlen des aushärtbaren Materials (28) in dem Bereich (26), so dass das aushärtbare Material (28) lateral entlang der Oberfläche (25) unterschiedlich schnell aushärtet, und Schwindungen beim Aushärten des aushärtbaren Materials (28) durch das weitere aushärtbare Material (29) ausgeglichen werden, wobei das lokal variierende Bestrahlen von einer der Abformoberfläche (14) abgewandten Seite des Abformwerkzeugs (12) durch das Abformwerkzeug (12) hindurch durchgeführt wird,
wobei das lokal variierende Bestrahlen mittels eines Strahls durchgeführt wird, der einen zwischen einer Strahlungsquelle (34) und dem Abformwerkzeug (12) angeordneten optischen Kanal (46) durchquert und während der Durchquerung eine Strahlbündelung erfährt;
**dadurch gekennzeichnet, dass** ein Teil einer von dem Abformwerkzeug (12) zurückgeworfenen Strahlung mit einem ein strahlteilenden Element (56) das von dem optischen Kanal umfasst wird, ausgekoppelt wird und der ausgekoppelte Teil (58') auf einen Bildsensor (64') abgebildet wird.

10. Verfahren gemäß Anspruch 9,
bei dem ein externer Druck (p₁) an das weitere aushärtbare Material (29) während des Bestrahlens angelegt wird.

11. Verfahren gemäß Anspruch 9 oder 10,
bei dem die lokal variierende Bestrahlung zumindest teilweise durch eine Struktur zur Strahldiffusion (72) hindurch erfolgt.

12. Verfahren gemäß einem der Ansprüche 9-11, ferner umfassend:
Aushärten eines Randbereichs aus aushärtbarem Material (28), der in lateral geschlossener Weise den Bereich (26) umschließt, zwischen dem Schritt des Anordnens des Abformwerkzeugs (12) und dem Schritt des lokal variierenden Bestrahlens.

13. Verfahren gemäß einem der Ansprüche 9-12,
bei dem eine Mehrzahl von Strukturen hergestellt wird; und bei dem die lokale Variation der Bestrahlung durch mittels Einstellung einer variierbaren Blendeneinheit (44) mit fixen Einzelblenden erfolgt, wobei ein Abstand der Einzelblenden dem einfachen oder mehrfachen Abstand der herzustellenden Strukturen entspricht.

14. Verfahren gemäß einem der Ansprüche 9-13,
bei dem das Anordnen und das lokal variierende Bestrahlen ferner unter Verwendung eines weiteren Abformwerkzeugs (12b-d) durchgeführt werden, um eine weitere Struktur herzustellen;
wobei Kanalstrukturen (22a; 22b) des Abformwerkzeugs (12a) mit Kanalstrukturen (22c-f) des weiteren Abformwerkzeugs (12b-d) fluidisch verbunden sind; und
wobei bei dem Anlegen des externen Drucks (p₁) an das weitere aushärtbare Material (29) während des Bestrahlens, der Druck in den Kanalstrukturen (22a-f) der Abformwerkzeuge (12a-d) aufgebracht wird.

15. Verfahren gemäß Anspruch 14,
bei dem eine oder mehrere weitere Strukturen zu einem Zeitpunkt ausgehärtet werden und die Strahlung (36) zum Aushärten des aushärtbaren Materials (28a-d) von zumindest einer Strahlungsquelle (34) emittiert wird;
wobei die Strahlung (36) eine Abstrahlfläche (45a-d) diffus verlässt und in Richtung jeder herzustellenden Struktur einen optischen Kanal (46a-d) durchquert.

## Claims

1. A device for manufacturing a structure made of a curable material by means of molding, comprising:
a molding tool (12) having a molding surface (14);
means for arranging the molding tool (14) above a surface (25) such that the curable material (28) is abutting on a region between the surface (25) and the molding surface (14), facing the surface (25), of the molding tool (12) and such that further curable material (29) may continue to flow to the region (26);
an image sensor (64'); and
an irradiation unit (32) comprising a radiation source (34) and an optical channel (46); wherein
the irradiation unit (32) is configured to perform locally varying irradiation of the curable material (28) in the region (26) such that the curable material (28) cures with varying speed laterally along the surface (25) in a varying manner and shrinking when curing the curable material (28) is compensated by the further curable material (29);
wherein the optical channel (46) comprises at least a first optical element (48; 52) for ray-shaping radiation (36) emitted by the radiation source (34) such that the radiation (36) experiences ray focusing when crossing the optical channel (46) in the direction towards the molding tool (12);
**characterized in that** the optical channel (46) comprises a ray-splitting element (56) configured to couple out part of radiation reflected from the molding tool (12) and to image the part (58') coupled out onto an image sensor (64').

2. The device in accordance with claim 1, wherein the reflected radiation is reflected by the molding tool based on the radiation (36) crossing the optical channel.

3. The device in accordance with claim 1 or 2,
wherein the radiation source (34) comprises a variable emission area (45) and the device comprises a further image sensor (64), wherein
the optical channel (46) comprises a ray-splitting element (56) configured to couple out part of the radiation (36) emitted by the radiation source (34) and to direct the part (58) coupled out to a projection or image area such that the emission area (45) is imaged onto the further image sensor (64).

4. The device in accordance with any of claims 1 to 3,
wherein the optical channel (46) comprises a first and a second ray-shaping element (48; 52) and the radiation (36) of the radiation source (34) is collimated and subsequently focused.

5. The device in accordance with any of the preceding claims, comprising:
a structure for ray diffusion (72) arranged between the radiation source (36) and the molding surface (14).

6. The device in accordance with any of the preceding claims, wherein:
the device is configured to manufacture a plurality of structures at the same time, the irradiation unit (32) comprising an optical channel (46a-d) and the molding tools (12a-d) comprising one molding surface (14a-d) per structure to be manufactured,
the radiation source (34) comprises a common radiation emitter, an optical element for ray scattering (42) and a variable shutter unit (44) with fixed individual shutters, wherein a distance of the individual shutters correspond to a distance of the structures to be manufactured and the optical element for ray scattering (42) and variable shutter unit (44) are arranged downstream of the radiation emitter in the ray direction such that diffuse radiation leaves the variable shutter unit through a variable emission area (45a-d) and is directed to the curable material (28a-d) through/by an optical channel (46a-d) per structure to be manufactured.

7. The device in accordance with any of the preceding claims, comprising:
a membrane layer (18a; 18b) arranged adjacent to the molding surface (14), wherein the membrane layer in a channel region of a tool substrate (16) which is laterally adjacent to the molding surface (14) locally abuts on the tool substrate (16) and is connected to the tool substrate (16) around the channel region in a fluid tight manner such that a region between the tool substrate (16) and the inside of the membrane layer (18a; 18b) forms an extendable channel structure (22a; 22b); and
the extendable channel structure (22a; 22b) is configured such that applying an external pressure (p₁) in the extendable channel structure (22a; 22b) induces a pressure in the further curable material (29).

8. The device in accordance with claim 7, further comprising another molding tool (12a-d) for manufacturing another structure;
wherein the extendable channel structures (22a; 22b) of the molding tool (12a) are fluidically connected to the extendable channel structures (22c-f) of the further molding tool (12b-d); and
wherein the extendable channel structures (22a-f) are configured such that applying the external pressure (p₁) in the extendable channel structures (22a-f) induces a pressure on the further curable material (29).

9. A method of manufacturing a structure made of a curable material (28) by means of molding, the method comprising:
arranging a molding tool (12) above a surface (25) such that the curable material (28) abuts on the surface (25) and a molding surface (14), facing the surface (25), of the molding tool (12) in a region (26) between the molding tool (12) and the surface (25) and such that further curable material (29) may continue to flow to the region (26);
irradiating the curable material (28) in the region (26) in a locally varying manner such that the curable material (28) cures at different speeds laterally along the surface (25) and shrinking when curing the curable material (28) is compensated by the further curable material (29), wherein irradiating in a locally varying manner is performed from a side, facing away from the molding surface (14), of the molding tool (12) through the molding tool (12),
wherein irradiating in a locally varying manner is performed by means of a ray crossing an optical channel (46) arranged between a radiation source (34) and the molding tool (12) and experiencing ray focusing while crossing;
**characterized in that** part of radiation reflected from the molding tool (12) is coupled out by a ray-splitting element (56) included by the optical channel and the part coupled out (58') is imaged onto an image sensor (64').

10. The method in accordance with claim 9,
wherein an external pressure (p₁) is applied to the further curable material (29) while irradiating.

11. The method in accordance with claim 9 or 10,
wherein irradiating in a locally varying manner takes place at least partly through a structure for ray diffusion (72).

12. The method in accordance with any of claims 9 to 11, further comprising:
curing an edge region made of curable material (28) which laterally completely encloses the region (26), between the step of arranging the molding tool (12) and the step of irradiating in a locally varying manner.

13. The method in accordance with any of claims 9 to 12,
wherein a plurality of structures are manufactured; and wherein the local variation of irradiating is done by means of setting a variable shutter unit (44) having fixed individual shutters, wherein a distance of the individual shutters corresponds to a single or multiple distances of the structures to be manufactured.

14. The method in accordance with any of claims 9 to 13,
wherein arranging and irradiating in a locally varying manner are additionally performed using another molding tool (12b-d) in order to manufacture another structure;
wherein channel structures (22a; 22b) of the molding tool (12a) are fluidically connected to channel structures (22c-f) of the further molding tool (12b-d); and
wherein, when applying the external pressure (p₁) to the further curable material (29) while irradiating, the pressure is applied in the channel structures (22a-f) of the molding tools (12a-d).

15. The method in accordance with claim 14,
wherein one or several further structures are cured at one time and the radiation (36) for curing the curable material (28a-d) is emitted by at least one radiation source (34);
wherein the radiation (36) leaves an emission area (45a-d) in a diffuse manner and crosses an optical channel (46a-d) in the direction of each structure to be manufactured.

## Revendications

1. Dispositif de fabrication d'une structure en matériau durcissable par moulage, aux caractéristiques suivantes:
un outil de moulage (12) avec une surface de moulage (14);
un moyen destiné à disposer l'outil de moulage (14) au-dessus d'une surface (25) de sorte que le matériau durcissable (28) soit adjacent à une zone comprise entre la surface (25) et la surface de moulage (14) de l'outil de moulage (12) orientée vers la surface (25) et de sorte qu'un autre matériau durcissable (29) puisse s'écouler vers la zone (26);
un capteur d'image (64'); et
une unité d'irradiation (32) avec une source de rayonnement (34) et un canal optique (46); où
l'unité d'irradiation (32) est conçue pour effectuer une irradiation variable localement du matériau durcissable (28) dans la zone (26) de sorte que le matériau durcissable (28) durcisse latéralement le long de la surface (25) de manière variable avec une rapidité différente, et que les contractions lors du durcissement du matériau durcissable (28) soient compensées par l'autre matériau durcissable (29);
dans lequel ledit canal optique (46) présente au moins un premier élément optique (48; 52) destiné à la formation de faisceau d'un rayonnement (36) émis par la source de rayonnement (34), de sorte que le rayonnement (36) subisse, lors de la traversée du canal optique (46) en direction de l'outil de moulage (12), un regroupement en faisceau du rayonnement;
**caractérisé par le fait que** le canal optique (46) comporte un élément de division de faisceau (56) qui est conçu pour découpler une partie du rayonnement réfléchie par l'outil de moulage (12) et pour reproduire la partie découplée (58') sur un capteur d'image (64').

2. Dispositif selon 1a revendication 1, dans lequel le rayonnement réfléchi est réfléchi par l'outil de moulage sur base du rayonnement (36) traversant le canal optique.

3. Dispositif selon la revendication 1 ou 2,
dans lequel la source de rayonnement (34) présente une surface de rayonnement variable (45) et le dispositif présente un autre capteur d'image (64),
le canal optique (46) comporte un élément de division de faisceau (56) qui est conçu pour découpler une partie du rayonnement (36) émis par la source de rayonnement (34) et pour diriger la partie découplée (58) vers une surface de projection ou d'image, de sorte que la surface de rayonnement (45) soit reproduite sur l'autre capteur d'image (64).

4. Dispositif selon l'une des revendications 1 à 3,
dans lequel le canal optique (46) comporte un premier et un deuxième élément de formation de faisceau (48; 52) et le rayonnement (36) de la source de rayonnement (34) est collimaté et ensuite focalisé.

5. Dispositif selon l'une des revendications précédentes, avec:
une structure de diffusion de faisceau (72) qui est disposée entre la source de rayonnement (36) et la surface de moulage (14).

6. Dispositif selon l'une des revendications précédentes, dans lequel:
le dispositif est conçu pour fabriquer en même temps une pluralité de structures, l'unité d'irradiation (32) présente un canal optique (46a à d) et les outils de moulage (12a à d) présentent une surface de moulage (14a à d) par structure à fabriquer,
la source de rayonnement (34) présente un émetteur de rayonnement commun, un élément optique pour la diffusion du faisceau (42) et une unité de diaphragmes variable (44) à diaphragmes individuels fixes, une distance entre les diaphragmes individuels correspondant à une distance entre les structures à fabriquer et l'élément optique pour la diffusion de faisceau (42) et l'unité de diaphragmes variable (44) étant disposée derrière l'émetteur de rayonnement dans la direction du faisceau de sorte que, par structure à fabriquer, un rayonnement diffus sorte de l'unité de diaphragmes variable par une surface de rayonnement variable (45a à d) et soit dirigé à travers un canal optique (46a à d) respectif vers le matériau durcissable (28a à d).

7. Dispositif selon l'une des revendications précédentes, avec
une couche de membrane (18a; 18b) disposée adjacente à la surface de moulage (14), où la couche de membrane s'appuie de manière lâche, dans une zone de canal d'un substrat d'outil (16) qui est latéralement adjacente à la surface de moulage (14), sur le substrat d'outil (16), et est connectée autour de la zone de canal de manière étanche aux fluides au support d'outil (16), de sorte qu'une zone entre le substrat d'outil (16) et le côté intérieur de la couche de membrane (18a; 18b) forme une structure de canal extensible (22a; 22b); et
la structure de canal extensible (22a; 22b) est réalisée de sorte qu'une application d'une pression externe (p₁) dans la structure de canal extensible (22a; 22b) induise une pression dans l'autre matériau durcissable (29).

8. Dispositif selon la revendications 7, comportant par ailleurs un autre outil de moulage (12a à d) destiné à fabriquer une autre structure;
dans lequel les structures de canal extensibles (22a, 22b) de l'outil de moulage (12a) sont connectées en fluide aux structures de canal extensibles (22c à f) de l'autre outil de moulage (12b à d); et
dans lequel les structures de canal extensibles (22a à f) sont réalisées de sorte que l'application de la pression externe (pi) dans les structures de canal extensibles (22a à f) induise une pression sur l'autre matériau durcissable (29).

9. Procédé de fabrication d'une structure en matériau durcissable (28) par moulage, le procédé présentant les étapes suivantes consistant à:
disposer un outil de moulage (12) au-dessus d'une surface (25), de sorte que, dans une zone (26) entre l'outil de moulage (12) et la surface (25), le matériau durcissable (28) soit adjacent à la surface (25) et à une surface de moulage (14) de l'outil de moulage (12) orientée vers la surface (25) et de sorte qu'un autre matériau durcissable (29) puisse s'écouler vers la zone (26);
irradier de manière variable localement le matériau durcissable (28) dans la zone (26), de sorte que le matériau durcissable (28) durcisse latéralement le long de la surface (25) avec une rapidité différente, et que les contractions lors du durcissement du matériau durcissable (28) soient compensées par l'autre matériau durcissable (29), où l'irradiation variable localement d'une face de l'outil de moulage (12) opposée à la surface de moulage (14) s'effectue à travers l'outil de moulage (12),
dans lequel l'irradiation variable localement est réalisée au moyen d'un faisceau qui traverse un canal optique (46) disposé entre une source de rayonnement (34) et l'outil de moulage (12) et qui subit un regroupement en faisceau pendant la traversée;
**caractérisé par le fait qu'**une partie d'un rayonnement réfléchi par l'outil de moulage (12) est découplée par un élément de division de faisceau (56) qui est compris dans le canal optique et que la partie découplée (58') est reproduite sur un capteur d'image (64').

10. Procédé selon la revendication 9,
dans lequel une pression externe (p₁) est appliquée sur un autre matériau durcissable (29) pendant l'irradiation.

11. Procédé selon la revendication 9 ou 10,
dans lequel l'irradiation variable localement est réalisée au moins partiellement à travers une structure de diffusion de faisceau (72).

12. Procédé selon l'une des revendications 9 à 11, comprenant par ailleurs le fait de:
durcir une partie de bordure de matériau durcissable (28) qui entoure la zone (26) de manière fermée latéralement, entre l'étape consistant à disposer l'outil de moulage (12) et l'étape consistant à irradier de manière variable localement.

13. Procédé selon l'une des revendications 9 à 12,
dans lequel est fabriquée une pluralité de structures; et dans lequel la variation locale de l'irradiation a lieu au moyen d'un réglage d'une unité de diaphragmes variable (44) avec des diaphragmes individuels fixes, où une distance entre les diaphragmes individuels correspond à la distance simple ou multiple entre les structures à fabriquer.

14. Procédé selon l'une des revendications 9 à 13,
dans lequel la disposition et l'irradiation variable localement sont par ailleurs effectuées à l'aide d'un autre outil de moulage (12b à d) pour fabriquer une autre structure;
dans lequel des structures de canal (22a; 22b) de l'outil de moulage (12a) sont connectées en fluide avec des structures de canal (22c à f) de l'autre outil de moulage (12b à d); et
dans lequel lors de l'application de la pression externe (p₁) sur l'autre matériau durcissable (29) pendant l'irradiation est appliquée la pression dans les structures de canal (22a à f) des outils de moulage (12a à d).

15. Procédé selon la revendication 14,
dans lequel une ou plusieurs autres structures sont durcies à un moment et le rayonnement (36) pour durcir le matériau durcissable (28a à d) est émis par au moins une source de rayonnement (34);
dans lequel le rayonnement (36) sort de manière diffuse d'une surface de rayonnement (45a à d) et traverse un canal optique (46a à d) en direction de chaque structure à fabriquer.
